# EUROPÄISCHE PATENTANMELDUNG

(11) **EP 3 121 854 A1**
(43) Veröffentlichungstag der Anmeldung: **25.01.2017**
(21) Anmeldenummer: 16180190.7
(22) Anmeldetag: 19.07.2016
(51) Int. Cl.: H01L 31/048, H02S 20/26

(54) **VERFAHREN ZUR HERSTELLUNG EINES VERBUNDES UND DAMIT HERGESTELLTER VERBUND**

(30) Priorität: 20.07.2015 AT 506372015
(71) Anmelder: SFL Technologies GmbH, 8152 Stallhofen (AT)
(72) Erfinder: HÖLLWARTH, Hans, 8042 Graz (AT); MÜLLER, Mario J., 8152 Kainbach bei Graz (AT)
(74) Vertreter: Wirnsberger, Gernot

(57) **Zusammenfassung**

Die Erfindung betrifft ein Verfahren zum Herstellen eines Verbundes (1) aus Glasscheiben (2) und einem Fotovoltaik-Paneel (3), umfassend die Schritte:
- Bereitstellen von zwei gekrümmten Glasscheiben (2) und einem an eine Krümmung der Glasscheiben (2) anformbares Fotovoltaik-Paneel (3),
- Anordnen des Fotovoltaik-Paneels (3) zwischen den Glasscheiben (2), wobei zwischen den Glasscheiben (2) und dem Fotovoltaik-Paneel (3) optional Zwischenschichten (4) angeordnet werden, und
- Verbinden der Glasscheiben (2), des Fotovoltaik-Paneels (3) und der optionalen Zwischenschichten (4) bei erhöhter Temperatur und erhöhtem Druck, um einen Verbund (1) herzustellen.

Weiter betrifft die Erfindung einen Verbund (1) aus Glasscheiben (2) und einem Fotovoltaik-Paneel (3), insbesondere zur Verwendung als Fassadenelement eines Gebäudes, wobei das Fotovoltaik-Paneel (3) innerhalb von zwei gekrümmten Glasscheiben (2) angeordnet ist, wobei der Verbund (1) eine gekrümmte Form ausbildet.

Des Weiteren betrifft die Erfindung eine Verwendung eines solchen Verbundes (1).

## Beschreibung

Die Erfindung betrifft ein Verfahren zur Herstellung eines Verbundes aus Glasscheiben und einem Fotovoltaik-Paneel.

Darüber hinaus betrifft die Erfindung einen Verbund aus Glasscheiben und einem Fotovoltaik-Paneel, insbesondere zur Verwendung als Fassadenelement eines Gebäudes.

Weiter betrifft die Erfindung eine Verwendung eines solchen Verbundes.

Aus dem Stand der Technik ist es bekannt, einen Verbund aus Glasscheiben und einem dazwischen eingefassten Fotovoltaik-Paneel an einer Fassade eines Gebäudes anzubringen. Dadurch wird einerseits eine Außenfläche eines Gebäudes dazu genutzt, aus Lichtenergie Strom zu erzeugen, und andererseits kann eine Außenfläche optisch ansprechend gestaltet werden. Dies beschränkt sich jedoch ausschließlich auf eben bzw. plan ausgebildete Außenflächen, da es nicht möglich ist, einen unebenen Verbund herzustellen, welcher eine beliebige zweidimensionale oder dreidimensionale Form aufweist. Es ist zwar bekannt, ein Fotovoltaik-Paneel in Flachgläser zu integrieren und einen solchen Verbund anschließend kalt vorzuspannen. Diese Methode ist jedoch zum einen aufwendig und zum anderen ist ein möglicher Biegeradius begrenzt.

Insbesondere Außenflächen von modernen Gebäuden werden jedoch vermehrt mit geschwungenen und gebogenen Oberflächen sowie mit wenigen Ecken und Kanten ausgebildet bzw. gestaltet. Ein derartiges Gebäude kann mit einem bekannten Verbund aus Glasscheiben und einem Fotovoltaik-Paneel jedoch nicht oder nicht vollständig verkleidet werden. Es ist folglich keine einheitliche Gestaltung von Außenflächen möglich. Darüber hinaus kann ein nicht unbeträchtlicher Teil einer Außenfläche nicht für eine Energieernte genutzt werden.

Hier setzt die Erfindung an. Aufgabe der Erfindung ist es, ein Verfahren der eingangs genannten Art anzugeben, mit welchem ein beliebig geformter Verbund aus Glasscheiben und einem Fotovoltaik-Paneel in einer einfachen Weise hergestellt werden kann.

Ein weiteres Ziel ist es, einen Verbund der eingangs genannten Art anzugeben, welcher passgenau an beliebig unebenen Außenflächen eines Gebäudes anbringbar ist.

Weiter ist es Ziel, eine Verwendung eines solchen Verbundes anzugeben.

Die Aufgabe wird erfindungsgemäß dadurch gelöst, dass ein Verfahren der eingangs genannten Art folgende Schritte umfasst:
- Bereitstellen von zwei gekrümmten Glasscheiben und einem an eine Krümmung der Glasscheiben anformbares Fotovoltaik-Paneel,
- Anordnen des Fotovoltaik-Paneels zwischen den Glasscheiben, wobei zwischen den Glasscheiben und dem Fotovoltaik-Paneel optional Zwischenschichten angeordnet werden, und
- Verbinden der Glasscheiben, des Fotovoltaik-Paneels und der optionalen Zwischenschichten bei erhöhter Temperatur und erhöhtem Druck, um einen Verbund herzustellen.

Ein mit der Erfindung erzielter Vorteil ist insbesondere darin zu sehen, dass durch das Einsetzen eines verformbaren Fotovoltaik-Paneels zwischen zwei bereits als gekrümmt bzw. gebogen bereitgestellte Glasscheiben in einer einfachen Weise ein als gekrümmter Fassadenschutz verwendbarer Verbund hergestellt wird. Eine Größe einer Krümmung bzw. ein Radius derselben kann dabei in weiten Bereichen beliebig sein. Zur Verwendung als Fassadenelement ist üblicherweise eine Herstellung eines zweidimensional gekrümmten Verbundes ausreichend. Es kann jedoch auch vorgesehen sein, dass ein Verbund mit einer sphärischen gekrümmten bzw. dreidimensionalen Form hergestellt wird. Die dazu verwendeten vollständig durchsichtigen Glasscheiben werden vor einer Herstellung des Verbundes mit Endabmessungen oder endabmessungsnah gefertigt. Durch das erfindungsgemäße Verfahren ist zudem eine Produktionszeit zum Herstellen eines gebogenen Verbundes im Vergleich zum Kaltvorspannen eines Verbundes aus Flachgläsern und einem Fotovoltaik-Paneel deutlich herabgesetzt. Das bereitgestellte Fotovoltaik-Paneel ist plattenförmig ausgebildet und kann beispielsweise polykristallin aus Silicium aufgebaut und außenseitig vorne und hinten mit einem Glasfaser-Kunststoff-Verbund versehen sein, um bei einer Biegung desselben wirkende Kräfte gleichmäßig zu verteilen. Insbesondere ist es günstig, wenn ein dünn und flexibel ausgebildetes Fotovoltaik-Paneel bereitgestellt wird, welches so in die Glasscheiben integriert wird, dass ein Verbund entsteht, beispielsweise durch Laminieren der einzelnen Elemente. Das Fotovoltaik-Paneel wird hierfür an die Form bzw. Fläche der Glasscheiben angepasst, welche uneben ausgebildet sind. Dabei entsprechen die zwei Glasscheiben bzw. deren Form einander. Der Verbund kann an dessen Kanten gesäumt werden. Durch das Einfassen des Fotovoltaik-Paneels in den Glasscheiben und das Bearbeiten eines solchen Rohverbundes bei erhöhter Temperatur und erhöhtem Druck wird ein formstabiler, hochwertiger und widerstandsfähiger bzw. robuster Verbund hergestellt, welcher eine gleichmäßige Gestaltung einer Fassade und eine Nutzung aller Außenflächen eines Gebäudes zu einer Energieernte ermöglicht. Plane Außenflächen eines Gebäudes werden dann mit einem entsprechenden planen Verbund aus planen Glasscheiben und einem Fotovoltaik-Paneel verkleidet. Ein solcher planer Verbund wird unter Verwendung von planen Glasscheiben entsprechend dem erfindungsgemäßen Verfahren hergestellt.

Zur Herstellung eines Verbundes können optional zwei Zwischenschichten vorgesehen sein, welche beidseitig am Fotovoltaik-Paneel zwischen den Glasscheiben angeordnet werden. Als Zwischenschicht wird bevorzugt ein Kunststoff verwendet, über welchen das Fotovoltaik-Paneel beidseitig mit einer Glasscheibe verbunden wird. Die Zwischenschicht kann beispielsweise eine Folie aus Polyvinylacetat oder Ethylenvinylacetat sein. Es ist günstig, wenn äußere Schichten des Fotovoltaik-Paneels eine gewisse Rauheit aufweisen bzw. nicht allzu glatt ausgebildet sind, sodass die Zwischenschicht daran haftet. Um ein Auftreffen von Sonnenlicht auf das Fotovoltaik-Paneel zu ermöglichen, ist neben den durchsichtigen Glasscheiben auch die Zwischenschicht transparent, zumindest an einer dem Licht zugewandten Seite des Verbundes. Insbesondere werden Glasscheiben, ein Fotovoltaik-Paneel und Zwischenschichten gleicher Abmessungen wie Fläche bzw. Seitenlängen bereitgestellt. Dabei kann eine Form der einzelnen Elemente bzw. des Verbundes beliebig sein, wobei zum Verkleiden einer Fassade eine in Draufsicht rechteckige Form des Verbundes besonders günstig ist.

Zweckmäßig ist es, wenn die Glasscheiben, das Fotovoltaik-Paneel und die Zwischenschichten in einem Vakuumsack angeordnet und zusammengepresst werden, um einen formstabilen, lang haltenden und eine hohe mechanische Beanspruchung aushaltenden Verbund herzustellen. Zum Zusammenpressen werden die einzelnen Elemente des Verbundes passgenau übereinandergelegt und in den Vakuumsack gegeben, welcher sodann evakuiert wird. Ein Druck bzw. Unterdruck im Vakuumsack kann dabei im Bereich von 0 mbar bis 500 mbar liegen, insbesondere kann dieser weniger als 350 mbar, bevorzugt weniger als 250 mbar, betragen.

Es ist weiter vorteilhaft, wenn der Verbund unter erhöhtem Druck im Bereich von etwa 7 bar bis 17 bar, bevorzugt im Bereich von 9 bar bis 15 bar, insbesondere bei etwa 12 bar, hergestellt wird. Dazu wird der Verbund bevorzugt vorher in den Vakuumsack gegeben, durch welchen die einzelnen Elemente durch Unterdruck aneinander gepresst werden. Der Verbund wird sodann im Vakuumsack für etwa 4 h bis 7 h, insbesondere etwa 5 h bis 6 h, in einem Autoklav bei Überdruck gelagert bzw. laminiert, wobei der Unterdruck im Vakuumsack während einer gesamten Verweildauer im Autoklav aufrechterhalten wird.

Es ist zudem besonders günstig, wenn der Verbund bei zumindest 130 °C, insbesondere im Bereich von 140 °C bis 200 °C, bevorzugt im Bereich von 170 °C bis 190 °C, besonders bevorzugt etwa bei 180 °C, hergestellt wird, um einen formstabilen Verbund herzustellen. Die Temperatur wie auch der Druck im Autoklav werden bevorzugt von außen eingestellt bzw. geregelt.

Es ist von Vorteil, wenn ein Fotovoltaik-Paneel aus in einem glasfaserverstärkten Kunststoff eingefassten polykristallinen Zellen aus Silicium bereitgestellt wird. Polykristalline Siliciumzellen sind im Vergleich zu anderen für eine Solarzelle geeigneten Halbleitermaterialien kostengünstig. Die polykristallinen Siliciumzellen werden mit Vorteil beidseitig mit einem transparenten Verbundmaterial bedeckt, wobei das Verbundmaterial aus Glasfasern und einem pulverförmigen Kunststoff hergestellt wird, beispielsweise durch Tempern. Besonders günstig ist es hierbei, wenn ein Brechungsindex der Glasfasern und des Kunststoffes im hergestellten Verbundmaterial im Wesentlichen gleich groß ist, um eine besonders hohe Transparenz des Verbundmaterials zu erreichen, sodass Licht möglichst ohne Streuung bzw. Reflexionen auf die polykristallinen Siliciumzellen trifft. Durch die Glasfasern im Verbundmaterial wird dieses mechanisch verstärkt, sodass das Fotovoltaik-Paneel ohne Beschädigung gebogen oder in eine beliebige Form gebracht werden kann. Weiter wird durch die durchsichtige Ausbildung der Glasfasern und des Kunststoffes stets eine hohe Lichtdurchlässigkeit begünstigt. Es kann günstig sein, wenn das Fotovoltaik-Paneel bei erhöhter Temperatur und erhöhtem Druck hergestellt wird, beispielsweise bei zumindest 130 °C und zumindest 7 bar.

Das weitere Ziel wird erreicht, wenn bei einem Verbund der eingangs genannten Art das Fotovoltaik-Paneel zwischen zwei gekrümmten Glasscheiben angeordnet ist, wobei der Verbund eine gekrümmte Form ausbildet.

Ein damit erzielter Vorteil ist insbesondere darin zu sehen, dass ein solcher Verbund als universelles Fassadenelement einsetzbar ist. Eine Krümmung bzw. Biegung des Verbundes ist dabei beliebig. Zur Verwendung in einer Fassade kann dieser bevorzugt zweidimensional gekrümmt sein. Es kann jedoch auch eine sphärisch gekrümmte Form mit einer dreidimensionalen Biegung des Verbundes vorgesehen sein. Die Glasscheiben sind dabei bereits vor einer Herstellung des Verbundes gekrümmt ausgebildet und umschließen das Fotovoltaik-Paneel, welches beliebig biegbar bzw. verformbar ausgebildet ist und an die Form der Glasscheiben angepasst bzw. in diese integriert wird. An den Kanten des Verbundes kann ein Saum angeordnet sein, welcher aus einem Metall, einer Metalllegierung oder aus einem Kunststoff gefertigt sein kann.

Es kann weiter günstig sein, wenn die Glasscheiben und das Fotovoltaik-Paneel zusammengepresst sind, wobei zwischen einer Glasscheibe und dem Fotovoltaik-Paneel eine Zwischenschicht vorgesehen ist. Das Zusammenpressen der einzelnen Elemente erfolgt in einem Vakuumsack, welcher evakuiert ist. Der Verbund wird bevorzugt in einem Autoklav hergestellt, wobei ein Druck und eine Temperatur in diesem bevorzugt erhöht sind. Das Fotovoltaik-Paneel ist außenseitig so ausgebildet, dass die Zwischenschicht aus insbesondere einem Kunststoff auf diesem haftet. Die Zwischenschicht stellt eine haltbare Verbindung zwischen den Glasscheiben und dem Fotovoltaik-Paneel her und kann beispielsweise aus Polyvinylacetat oder Ethylenvinylacetat gebildet sein.

Es ist vorteilhaft, wenn das Fotovoltaik-Paneel polykristalline Zellen aus Silicium umfasst. Ein solches Fotovoltaik-Paneel ist kostengünstig herstellbar. Die polykristallinen Siliciumzellen sind mit Vorteil beidseitig mit einem transparenten Verbundmaterial bedeckt, wobei das Verbundmaterial aus Glasfasern und einem pulverförmigen Kunststoff bevorzugt bei erhöhter Temperatur und erhöhtem Druck hergestellt wird, beispielsweise durch Tempern. Besonders günstig ist es hierbei, wenn ein Brechungsindex der Glasfasern und des Kunststoffes im hergestellten Verbundmaterial im Wesentlichen gleich groß ist, um eine besonders hohe Transparenz des Verbundmaterials zu erreichen. Durch die Glasfasern im Verbundmaterial ist dieses mechanisch verstärkt, wobei diese durch deren durchsichtige Ausbildung stets eine hohe Lichtdurchlässigkeit begünstigen. Die Glasfasern können weiter als Gewebe mit einem Flächengewicht im Bereich von 50 g/m² bis 600 g/m², insbesondere im Bereich von 100 g/m² bis 400 g/m², bevorzugt im Bereich von 160 g/m² bis 340 g/m², ausgebildet sein. Es kann weiter vorgesehen sein, dass das Gewicht des Gewebes an einer dem Licht abgewandten Seite höher ist als an einer dem Licht zugewandten Seite, beispielsweise 1,5-mal bis 2,5-mal so hoch. Es ist somit einerseits eine Belastbarkeit des gesamten Fotovoltaik-Paneels erhöht und andererseits ein Gewicht desselben niedrig gehalten. Weiter kann das Glasfasergewebe aus 1 bis 10, bevorzugt 4 bis 6, zusammengelegten Garnen gebildet sein, wobei eine Feinheit von Kettgarnen im Bereich von 30 tex bis 120 tex, bevorzugt im Bereich von 50 tex bis 100 tex, insbesondere im Bereich von 60 tex bis 70 tex, liegen kann. Eine Feinheit von Schussgarnen hingegen kann im Bereich von 100 tex bis 500 tex, bevorzugt im Bereich von 200 tex bis 350 tex, insbesondere im Bereich von 270 tex bis 300 tex, liegen.

Eine Verwendung eines erfindungsgemäßen Verbundes erfolgt mit Vorteil als Fassadenelement für ein Gebäude.

Weitere Merkmale, Vorteile und Wirkungen ergeben sich aus den nachfolgend dargestellten Ausführungsbeispielen. In den Zeichnungen, auf welche dabei Bezug genommen wird, zeigen:
- Fig. 1: eine Explosionsdarstellung eines erfindungsgemäßen Verbundes;
- Fig. 2: einen weiteren erfindungsgemäßen Verbund.

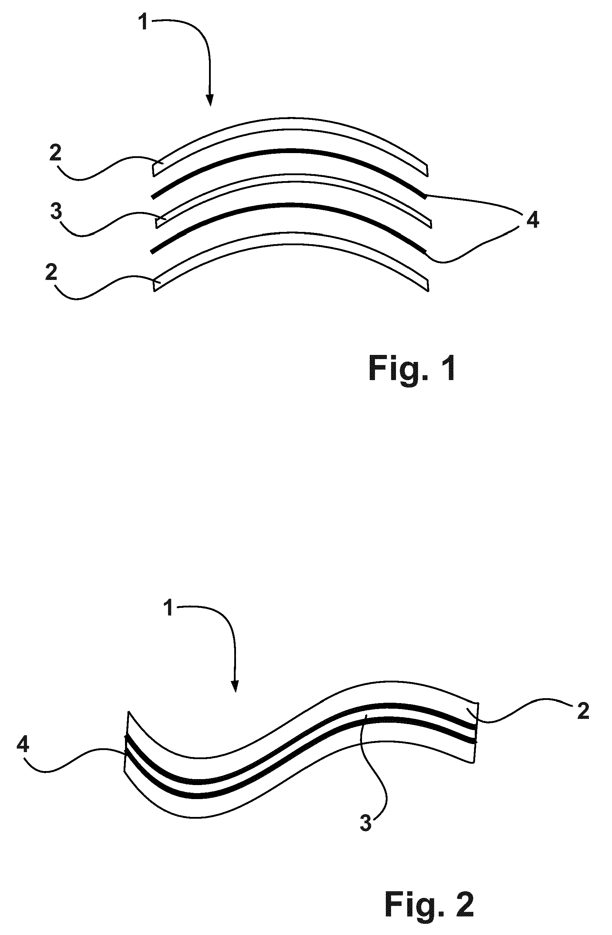

Fig. 1 zeigt eine Explosionsdarstellung eines erfindungsgemäßen Verbundes 1. Der Verbund 1 umfasst zwei gekrümmte bzw. gebogene Glasscheiben 2 und ein Fotovoltaik-Paneel 3. Die Glasscheiben 2 sind bereits uneben bzw. nicht plan ausgebildet, wohingegen das Fotovoltaik-Paneel 3 biegbar bzw. flexibel ausgebildet ist. Das Fotovoltaik-Paneel 3 ist dadurch auf beliebige, unebene Flächen anpassbar. Zum Herstellen eines Verbundes 1 wird dieses der Form der Glasscheiben 2 angepasst, wobei beide Glasscheiben 2 dieselbe Form aufweisen. Das Fotovoltaik-Paneel 3 kann so in den Glasscheiben 2 integriert sein, dass dessen optisch aktive Seite eine konvexe Form ausbildet. Es ist jedoch auch möglich, dass dieses eine konkave Form ausbildend zwischen den Glasscheiben 2 angeordnet ist, abhängig von einer Verwendung des Verbundes 1.

Günstig ist es, wenn zwischen jeweils einer Glasscheibe 2 und dem Fotovoltaik-Paneel 3 eine Zwischenschicht 4 vorgesehen ist. Die Zwischenschicht 4 kann als Folie aus Polyvinylacetat oder Ethylenvinylacetat ausgebildet sein und stellt eine Verbindung zwischen den Glasscheiben 2 und dem Fotovoltaik-Paneel 3 her.

In Fig. 2 ist ein weiterer erfindungsgemäßer Verbund 1 gezeigt. Dieser weist eine geschwungene bzw. zweifach gewölbte Form auf. Ein Verbund 1 kann aus beliebig geformten Glasscheiben 2 gebildet sein, wobei das verformbare Fotovoltaik-Paneel 3 an die Form der Glasscheiben 2 angepasst wird. Die Glasscheiben 2 sind mit einer geringen Dicke von 10 mm oder weniger, bevorzugt 7 mm oder weniger, insbesondere 5 mm oder weniger, ausgebildet.

Beim Herstellen eines Verbundes 1 werden zwei gekrümmte Glasscheiben 2 und ein verformbares Fotovoltaik-Paneel 3 bereitgestellt, wobei das Fotovoltaik-Paneel 3 zwischen den Glasscheiben 2 angeordnet bzw. in diese integriert wird. Zum Verbinden der Glasscheiben 2 mit dem Fotovoltaik-Paneel 3 kann dazwischen jeweils eine Zwischenschicht 4 angeordnet werden. Bevorzugt wird der Verbund 1 in einem Autoklav hergestellt, in welchem ein Druck und eine Temperatur erhöht sind. Günstig ist es hierzu, wenn die einzelnen Elemente des Verbundes 1 passgenau übereinandergelegt und in einem sogenannten Vakuumsack angeordnet werden, welcher evakuiert wird, sodass die Glasscheiben 2, das Fotovoltaik-Paneel 3 und die Zwischenschichten 4 zusammengepresst werden. Im Autoklav werden die einzelnen Elemente einige Stunden thermisch behandelt, sodass ein formstabiler Verbund 1 hergestellt wird. Die Zwischenschichten 4 sind nach der Behandlung im Autoklav durchsichtig, um bei einer Anwendung des Verbundes 1 ein ungehindertes Auftreffen von Sonnenlicht auf das Fotovoltaik-Paneel 3 zu ermöglichen. Gleichzeitig wird eine Verbindung des Fotovoltaik-Paneels 3 mit den Glasscheiben 2 durch die als Laminat ausgebildete Zwischenschicht 4 hergestellt. Hierzu ist eine Oberfläche des Fotovoltaik-Paneels 3 zweckmäßigerweise so beschaffen, dass eine Haftung der Zwischenschichten 4 gegeben ist, beispielsweise kann diese einen hohen Reibungskoeffizienten aufweisen. Das Fotovoltaik-Paneel 3 ist mit Vorteil temperaturbeständig ausgebildet, sodass dieses auch nach der Behandlung im Autoklav vollständig einsatzfähig ist. Dazu werden von diesem einerseits eine erhöhte Temperatur über eine längere Zeitdauer und andererseits ein Abkühlprozess nach der thermischen Behandlung ohne Beschädigungen überstanden. Weiter werden vom Fotovoltaik-Paneel 3 auch hohe Drücke unbeschadet überstanden. Analoges gilt auch für die Glasscheiben 2. Das Fotovoltaik-Paneel 3 wird weiter vorteilhaft aus polykristallinen Siliciumzellen gebildet, welche beidseitig von einem glasfaserverstärktem Kunststoff eingefasst werden.

## Patentansprüche

1. Verfahren zum Herstellen eines Verbundes (1) aus Glasscheiben (2) und einem Fotovoltaik-Paneel (3), umfassend die Schritte:
- Bereitstellen von zwei gekrümmten Glasscheiben (2) und einem an eine Krümmung der Glasscheiben (2) anformbares Fotovoltaik-Paneel (3),
- Anordnen des Fotovoltaik-Paneels (3) zwischen den Glasscheiben (2), wobei zwischen den Glasscheiben (2) und dem Fotovoltaik-Paneel (3) optional Zwischenschichten (4) angeordnet werden, und
- Verbinden der Glasscheiben (2), des Fotovoltaik-Paneels (3) und der optionalen Zwischenschichten (4) bei erhöhter Temperatur und erhöhtem Druck, um einen Verbund (1) herzustellen.

2. Verfahren nach Anspruch 1, **dadurch gekennzeichnet, dass** die Glasscheiben (2), das Fotovoltaik-Paneel (3) und die Zwischenschichten (4) in einem Vakuumsack angeordnet und zusammengepresst werden.

3. Verfahren nach Anspruch 1 oder 2, **dadurch gekennzeichnet, dass** der Verbund (1) unter erhöhtem Druck im Bereich von etwa 7 bar bis 17 bar, bevorzugt im Bereich von 9 bar bis 15 bar, insbesondere bei etwa 12 bar, hergestellt wird.

4. Verfahren nach einem der Ansprüche 1 bis 3, **dadurch gekennzeichnet, dass** der Verbund (1) bei zumindest 130 °C, insbesondere im Bereich von 140 °C bis 200 °C, bevorzugt im Bereich von 170 °C bis 190 °C, besonders bevorzugt etwa bei 180 °C, hergestellt wird.

5. Verfahren nach einem der Ansprüche 1 bis 4, **dadurch gekennzeichnet, dass** ein Fotovoltaik-Paneel (3) aus in einem glasfaserverstärkten Kunststoff eingefassten polykristallinen Zellen aus Silicium bereitgestellt wird.

6. Verbund (1) aus Glasscheiben (2) und einem Fotovoltaik-Paneel (3), insbesondere zur Verwendung als Fassadenelement eines Gebäudes, **dadurch gekennzeichnet, dass** das Fotovoltaik-Paneel (3) zwischen zwei gekrümmten Glasscheiben (2) angeordnet ist, wobei der Verbund (1) eine gekrümmte Form ausbildet.

7. Verbund (1) nach Anspruch 6, **dadurch gekennzeichnet, dass** die Glasscheiben (2) und das Fotovoltaik-Paneel (3) zusammengepresst sind, wobei zwischen einer Glasscheibe (2) und dem Fotovoltaik-Paneel (3) eine Zwischenschicht (4) vorgesehen ist.

8. Verbund (1) nach Anspruch 6 oder 7, **dadurch gekennzeichnet, dass** das Fotovoltaik-Paneel (3) polykristalline Zellen aus Silicium umfasst.

9. Verwendung eines Verbundes (1) nach einem der Ansprüche 6 bis 8 als Fassadenelement für ein Gebäude.
